# EUROPEAN PATENT SPECIFICATION

(11) **EP 1 812 960 B1**
(45) Date of publication and mention of the grant of the patent: **21.09.2011**
(21) Application number: 05821306.7
(22) Date of filing: 17.11.2005
(51) Int. Cl.: H01L 21/00, H01J 37/32, G01J 3/443, G01N 21/68, H01L 21/3065

(54) **DRY ETCHING APPARATUS AND METHODS OF FORMING AN ELECTRIC DEVICE USING THE SAME**
TROCKENÄTZVORRICHTUNG UND VERFAHREN ZUR HERSTELLUNG EINER ELEKTRONISCHEN VORRICHTUNG DAMIT
APPAREIL DE GRAVURE SECHE ET PROCEDE DE FORMATION D'UN DISPOSITIF ELECTRIQUE LES UTILISANT

(30) Priority: 14.11.2005 KR 20050108791; 18.11.2004 KR 20040094687
(43) Date of publication of application: 01.08.2007
(73) Proprietor: Semisysco Co., Ltd., Gyeonggi-do 442-834 (KR)
(72) Inventor: LEE, Soon-jong, Gyeonggi-do 463-708 (KR); WOO, Bong-joo, Gyeonggi-do 463-713 (KR); LEE, Dong-seok, Gyeonggi-do 443-470 (KR)
(74) Representative: Hengelhaupt, Jürgen
(86) International application number: PCT/KR2005/003907
(87) International publication number: WO 2006/054871

(56) References cited:
- JP-A- 2000 357 679
- US-A- 5 290 383
- US-A- 5 494 712
- US-A- 5 980 767
- US-A- 6 077 387
- US-A- 6 090 302
- US-A1- 2003 085 198
- US-A1- 2004 198 064
- US-A1- 2004 238 489
- US-B1- 6 200 822
- US-B1- 6 417 013

## Description

### Technical Field

The present invention relates to dry etching apparatuses, dry etching end point detecting apparatuses, and methods of forming electric devices using the dry etching apparatuses, and more particularly, to dry etching apparatuses and dry etching end point detecting apparatuses used in a Bosch process, and methods of forming electric devices using the dry etching apparatuses.

### Background Art

Recently, electric devices are fabricated by new semiconductor manufacturing apparatuses as a design rule is gradually downscaled with a tendency of high integration. The semiconductor manufacturing apparatuses each has process recipes for reducing a manufacturing process period of the electric device on a semiconductor manufacturing line.

One of the process recipes is referred to as a Bosch process of repeatedly performing etching and deposition processes on a substrate having material layers in the process chamber of a dry etching apparatus in situ. The Bosch process makes use of different process gases while the etching and deposition processes are performed on the substrate. And, the Bosch process can contribute to quality improvement of the electric device because the etching and deposition processes are performed on the substrate in situ. For this reason, the Bosch process is widely applied to production of micro-electro-mechanical systems (MEMSs) as the electric devices.

However, the dry etching apparatus may fail to find an etching end point on one selected from the material layers on the substrate while the etching and deposition processes are performed, because the dry etching apparatus has information on etching and deposition by the aid of plasma light generated by the process gases in the process chamber. Moreover, the dry etching apparatus applies an algorithm called the "moving average method" in order to find the etching end point. etching and deposition processes into predetermined time intervals, and finding the sum of frequencies of the plasma light corresponding to a plurality of points of time within any one of the time intervals. Subsequently, the moving average method further includes dividing the sum of the frequencies of the plasma light by a total number of the plurality of time points, and repeatedly performing the dividing of the sum of the frequencies using other time intervals to transform the plasma light to an optical image.

When failing to find the etching end point using the optical image, the dry etching apparatus may apply the moving average method to the plasma light several times. At this time, the etching and deposition information of the substrate may be mixed in the optical image. As a result, the dry etching apparatus fails to find the etching end point on one selected from the material layers on the substrate using the optical image.

Reference is also made to prior art documents US-A-2003085198, US-A-5200383, US-B1-6,200822; US-A-6,090,302 and US-A-5,980,767.

### Disclosure of Invention

### [Technical Problem]

It is, therefore, an objective of the present invention to provide dry etching apparatuses and dry etching end point detecting apparatuses used in a Bosch process, which are suitable to separate plasma light having etching information of a substrate while the etching and deposition processes are repeatedly performed.

It is another objective of the present invention to provide methods of forming electric devices using dry etching apparatuses used in a Bosch process that is capable of separating plasma light of etching processes to check etching information of a substrate while the etching and deposition processes are repeatedly performed.

### [Technical Solution]

In order to accomplish these objectives, the present invention provides a dry etching apparatus according to claim 1 and a method of forming electric devices using the dry etching apparatus according to claim 16 The dry etching apparatus includes a process chamber and an optical window. The optical window is disposed on a sidewall of the process chamber. The optical window projects the plasma light out of the process chamber during the etching and

### [Advantageous Effects]

As set forth above, the present invention provides a method of efficiently fabricating the electric device by separating the plasma light having etching information of the substrate while the etching and deposition processes are repeatedly performed. Thereby, the present invention can obtain the electric device from the substrate with a high yield by using the plasma light having the etching information of the substrate.

The forgoing embodiment is merely exemplary and is not to be construed as limiting the present invention. The present teachings can be readily applied to other types of apparatuses. The description of the present invention is intended to be illustrative, and not to limit the scope of the claims. Many alternatives, modifications, and variations will be apparent to those skilled in the art.

### Brief Description of the Drawings

The above and other features and advantages of the present invention will become more apparent to those of ordinary skill in the art by describing in detail preferred embodiments thereof with reference to the attached drawings in which:
FIG. 1 is a schematic diagram of a dry etching apparatus according to the present invention;
FIGS. 2 and 3 are schematic diagrams of an optical screener in the dry etching apparatus of FIG. 1, respectively;
FIG. 4 is a graph schematically showing an image locus of the plasma light generated by the dry etching apparatus of FIG. 1;
FIGS. 5 to 9 are cross-sectional views illustrating a method of fabricating an electric device using the dry etching apparatus of FIG. 1, respectively;
FIG. 10 is a flowchart illustrating an operation program of the dry etching apparatus of FIG. 1
FIGS. 11 and 12 are graphs showing an image locus of plasma light generated while the etching and deposition processes of FIGS. 5 to 9 are performed, respectively;
FIG. 13 and 14 are graphs showing an image locus of plasma light generated while the deposition processes of FIGS. 5 to 9 are performed, respectively; and
FIGS. 15 and 16 are graphs showing an image locus of plasma light generated while the etching processes of FIGS. 5 to 9 are performed, respectively.

### Best mode for Carrying Out the Invention

Dry etching apparatuses and dry etching end point detecting apparatuses used in a Bosch process, and methods of forming electric devices using the dry etching apparatuses will now be described more fully hereinafter with reference to the accompanying drawings, in which preferred embodiments of the invention are shown.

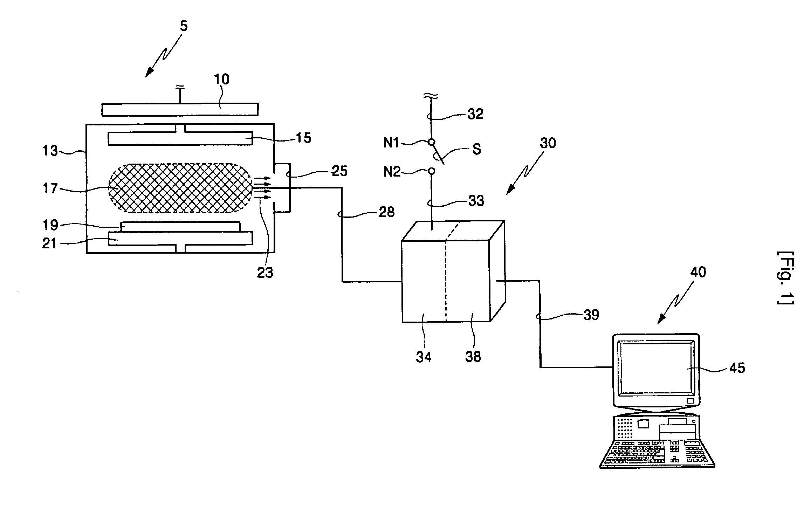

FIG. 1 is a schematic diagram of a dry etching apparatus according to the present invention.

Referring to FIG. 1, a process chamber 13 is provided in the dry etching apparatus. The process chamber 13 is provided therein with upper and lower electrodes 15 and 21. Alternatively, when the upper electrode 15 is not provided, a magnetic field generator 10 may be provided over the process chamber 13. In this case, the magnetic field generator 10 has a coil form, and produces a magnetic field varying according to the time and direction over the process chamber 13. Thereby, the magnetic field generator 10 can induce the electric field around the lower electrode 21 in the process chamber 13.

An optical window 25 is provided on one side of the process chamber 13. The optical window 25 transmits plasma light 23, which is generated by reacting plasma 17 with a substrate 19 in the process chamber 13, to the outside. The plasma light 23 can be generated during a Bosch process. The Bosch process is a process recipe of sequentially and repeatedly performing etching and deposition processes on the substrate 19 using the plasma 17 in the process chamber 13. An optical module 30 is provided around the process chamber 13. The optical module 30 captures the plasma light 23 in the process chamber 13, and analyzes the plasma light 23. The optical module 30 is composed of an optical condenser 34 and an optical analyzer 38.

First, the optical condenser 34 and its surroundings will be described. The optical condenser 34 is interposed between the optical analyzer 38 and the optical window 25. An optical probe 28 is interposed between the optical window 25 and the optical condenser 34. The optical probe 28 has one end extending through the optical window 25 to the process chamber 13. The other end of the optical probe 28 is disposed so as to come into contact with the optical condenser 34. The optical probe 28 includes an optical fiber capable of monitoring the plasma light 23 in the process chamber 13 using a monitor 45.

Meanwhile, the optical condenser 34 can capture the plasma light 23 in the process chamber 13 through the optical probe 28. The plasma light 23 can be captured in an optical filter, a monochrometer, or a charge coupled device (CCD). The CCD, preferably, has a resolution of 0.1 to 10 nm within a wavelength band of 200 to 1100 nm. At this time, the optical condenser 34 captures the plasma light 23 through an operation program of the dry etching apparatus 5 while the Bosch process is performed. The plasma light 23 is converted into electrical data through the optical condenser 34. Thereby, the optical condenser 34 can transmits the plasma light 23 to the optical analyzer 38.

Next, the optical analyzer 38 is electrically connected to the optical condenser 34, and receives the plasma light 23 from the optical condenser 34, thereby generating an optical image (not shown). The optical image is formed into binary data that can be recognized by a computer. Further, the optical analyzer 38 can generate an image locus from the optical image using another moving average method that is different from a conventional moving average method. According to the present invention, the moving average method includes a step of dividing the process time of any one of the etching and deposition processes of the Bosch process into a predetermined number of time intervals, and a step of finding a sum of frequencies of the plasma light 23 which correspond to a plurality of time points within any one of the time intervals.

Further, the moving average method further includes a step of dividing the sum of the frequencies of the plasma light 23 by a total number of the plurality of time points, and a step of repeatedly performing the step of dividing the sum by the total number using other time intervals. The moving average method can be performed through the optical analyzer 38 once or more. The total number of the time points is a sum of the time points when the plasma light 23 is repeatedly measured within the respective time intervals. At this time, the optical image has a waveform smoother than that of the plasma light 23. Thereby, the optical analyzer 38 can transmit the optical image to the main computer 40.

Finally, the main computer 40 is connected to the optical analyzer 38 through an electric wire 39. The main computer 40 receives the optical image from the optical analyzer 38 to present the image locus on the monitor 45. The image locus lays out magnitudes of the frequencies of the plasma light to which the moving average method is applied according to the process time of the Bosch process.

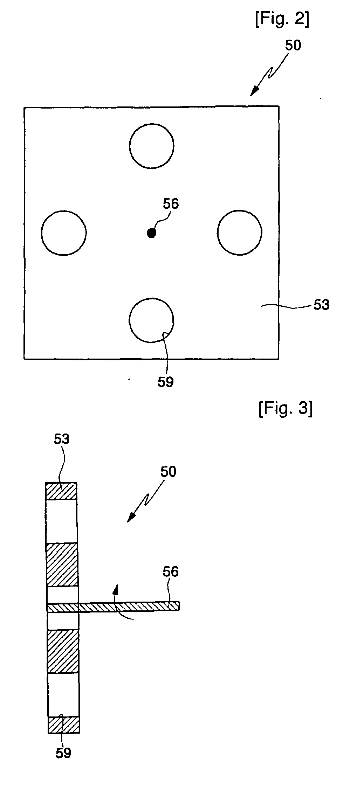

FIGS. 2 and 3 are schematic diagrams of an optical screener in the dry etching apparatus of FIG. 1, respectively.

Referring to FIGS. 1 to 3, the optical condenser 34 in the dry etching apparatus 5 can selectively, periodically capture the plasma light 23 for the process time of the Bosch process. The optical condenser 34 is capable of selectively, periodically capturing the plasma light 23 through the operation program or optical screener 50 of the dry etching apparatus 5. Of course, the optical screener 50 is actuated through the operation program of the dry etching apparatus 5. The following description will be made regarding the optical screener 50, and an algorithm of the operation program in that order.

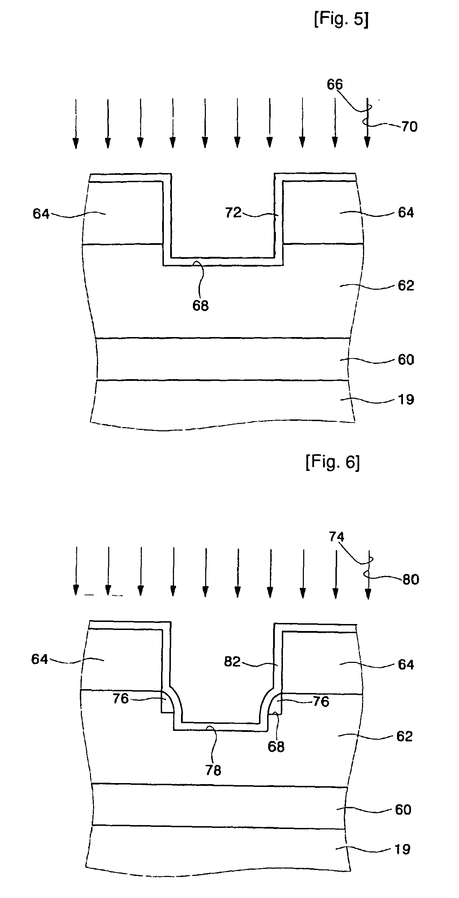

When provided in the dry etching apparatus 5, the optical screener 50 is interposed between the optical window 25 and the optical probe 28. At this time, one end of the optical probe 28 is spaced apart from the optical screener 50 so as to be opposite to the optical screener 50. And the other end of the optical probe 28 is located in the optical condenser 34. Further, the optical screener 50 is formed so as to have a plurality of apertures 59, and a light shielding layer 53 defining the apertures 59. FIG. 3 is a side view showing the optical screener 50 of FIG. 5.

In the optical screener 50, the apertures 59 are arranged to be symmetric about the center of the light shielding layer 53. Alternatively, the apertures 59 may be arranged to be asymmetric with respect to the center of the light shielding layer 53. The apertures 59 of the optical screener 50 are arranged on a circle with a predetermined radius from the center of the light shielding layer 53. And the apertures 59 of the optical screener 50 are arranged on the light shielding layer 53 so as to have the same diameter. Alternatively, the apertures 59 of the optical screener 50 may be arranged on the light shielding layer 53 so as to have a different diameter. At this time, the optical probe 28 is disposed to face one of the apertures 59 of the optical screener 50.

The optical screener 50 may have a support rod 56 so as to be rotatable around the optical window 25. Thus, the optical screener 50 rotates around the optical window 25 in a constant direction. A period of passing between the apertures 59 of the optical screener 50 is adjusted to be the same as that of repeatedly performing the etching process of the etching and deposition processes for the process time of the Bosch process. Alternatively, the period of passing between the apertures 59 of the optical screener 50 may be adjusted to be the same as that of repeatedly performing the deposition process of the etching and deposition processes for the process time of the Bosch process. Thereby, the optical condenser 34 can selectively, periodically capturing the plasma light 23 through the optical screener 50 for the process time of the Bosch process.

In this manner, the optical screener 50, optical probe 28, optical condenser 34, optical analyzer 38 and main computer 40 constitute a dry etching end point detecting apparatus.

Next, the optical condenser 34 in the dry etching apparatus 5 can selectively, periodically capture the plasma light 23 for the process time of the Bosch process through the operation program instead of the optical screener 50. At this time, only the optical probe 28 is interposed between the optical condenser 34 and the process chamber 13. The operation program has an algorithm of causing the plasma light 23 of the etching and deposition processes for the process time of the Bosch process to be continuously captured in the optical condenser 34, and thereafter selecting the plasma light 23 of the etching process.

According to the algorithm of the operation program, the operation program includes a step of continuously capturing the plasma light 23 through the optical condenser 34 while the etching and deposition processes are performed in the process chamber 13. And, by comparing a magnitude of the frequencies of the plasma light 23 with a tolerance of at least one reference value in the operation program, and by determining the comparison result, the optical condenser 34 extracts the plasma light 23 corresponding to one of the etching and deposition processes.

Finally, the optical condenser 34 in the dry etching apparatus 5 receives different electrical signals for the process time of the Bosch process to selectively, periodically capture the plasma light 23 though the optical program. At this time, only the optical probe 28 is interposed between the optical condenser 34 and the process chamber 13. The operation program has an algorithm of causing the different electrical signal whenever performing the etching and deposition processes in the process chamber 13 for the process time of the Bosch process to be transmitted to the optical condenser 34.

According to another algorithm of the operation program, the operation program includes a step of applying an electrical signal, for example a voltage value of '0' or more, to one 32 of the signal lines 32 and 33. And the electrical signal is connected with or disconnected from electrical nodes N1 and N2, which are provided to the signal lines 32 and 33 respectively, by a switch S. When the electrical nodes N1 and N2 are connected to each other, the electrical signal is transmitted to the other signal line 33, and thereby the operation program causes the optical condenser 34 to capture the plasma light 23 while the etching process is performed in the process chamber 13. In contrast, when the electrical nodes N1 and N2 are disconnected from each other, the operation program causes the optical condenser 34 to capture the plasma light 23 while the deposition process is performed in the process chamber 13.

In this manner, the signal lines 32 and 33, electric nodes N1 and N2, switch S, optical probe 28, optical condenser 34, optical analyzer 38, and main computer 40 constitute another dry etching end point detecting apparatus.

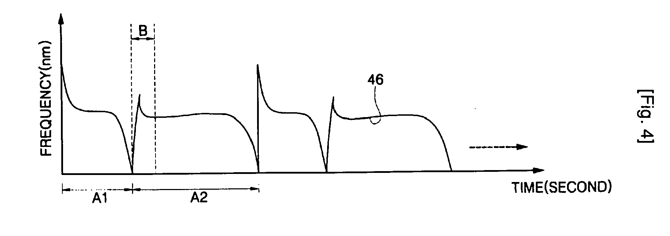

FIG. 4 is a graph schematically showing an image locus of the plasma light generated by the dry etching apparatus of FIG. 1.

Referring to FIGS. 1 and 4, the optical condenser 34 captures the plasma light 23 of etching and deposition processes according to the process time when the Bosch process is performed through the operation program. The optical condenser 34 sends the plasma light 23 to the optical analyzer 38. The optical analyzer 38 generates the optical image from the plasma light 23, and then transmits the optical image to the main computer 40. The main computer 40 receives the optical image of the optical analyzer 38 to display the image locus 46 of FIG. 4 on the monitor 45.

In the meantime, the image locus 46 is plotted on the graph where the process time is allotted to an X axis by second, and the plasma light 23 is allotted to a Y axis by frequency. Thus, the image locus 46 is to lay out sections A1 and A2 corresponding to the deposition and etching processes according to the process time by periods.

However, the dry etching apparatus 5 fails to precisely plot the image locus 46 according to the process time, because different process gases are used in the deposition and etching processes while the Bosch process is performed. Specifically, this is because the dry etching apparatus 5 can not fully exhaust the process gas of the deposition process in an initial section where the etching process begins. Similarly, the dry etching apparatus 5 can not fully exhaust the process gas of the etching process at a point of time when the deposition process begins. This is responsible for a limit to exhaust capability of the dry etching apparatus 5. Hence, the dry etching apparatus 5 may have a mixture gas consisting of the process gases of the deposition and etching processes in the initial section where the etching process begins.

In order to exclude the influence of the mixture gas while the Bosch process is performed, the dry etching apparatus 5 controls the optical condenser 34 to capture the plasma light 23 through the other algorithm of the operation program after a time, which corresponds to the initial section B from the time point when the deposition or etching process begins, has lapsed. In contrast, the dry etching apparatus 5 controls the optical analyzer 38 to analyze the plasma light 23 through the other algorithm of the operation program after a time, which corresponds to the initial section B from the time point when the deposition or etching process begins, has lapsed.

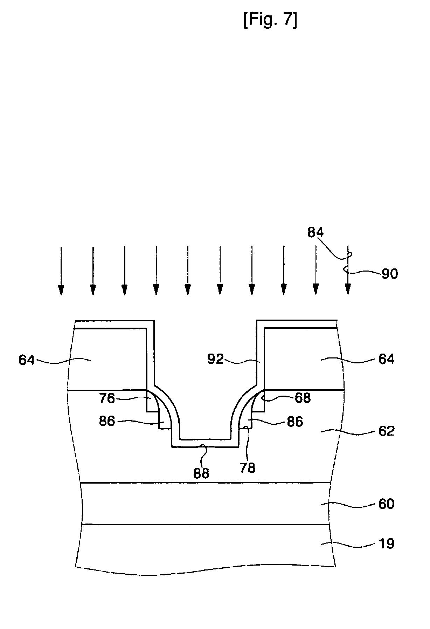

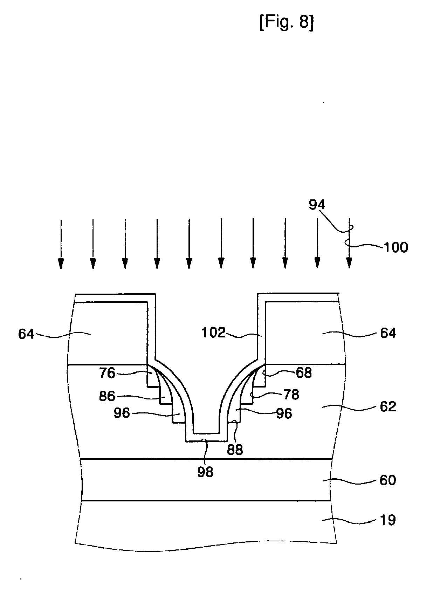

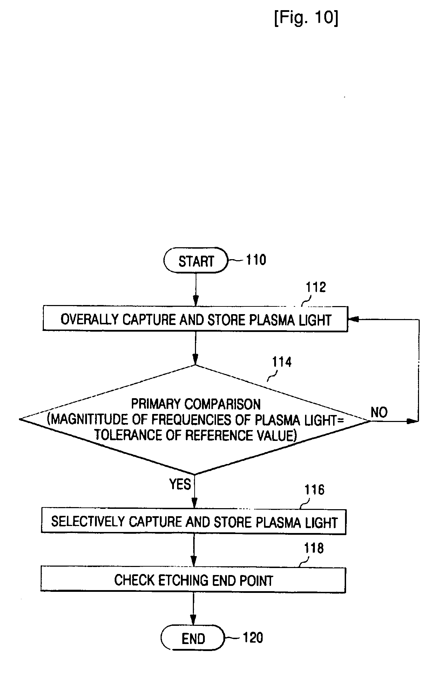

FIGS. 5 to 9 are cross-sectional views illustrating a method of fabricating an electric device using the dry etching apparatus of FIG. 1, respectively, and FIG. 10 is a flowchart illustrating an operation program of the dry etching apparatus of FIG. 1.

Referring to FIGS. 1, 5 and 10, the substrate 19 is inserted into the process chamber 13 of the dry etching apparatus 5. The substrate 19 may be placed on the lower electrode 21 in the process chamber 13. Subsequently, the process gas for the etching process is introduced into the process chamber 13. Power is applied to the lower electrode 21, and the upper electrode 15 corresponding to the lower electrode 21. At this time, an electric field is formed between the upper and lower electrodes 15 and 21.

The dry etching apparatus 5 converts the process gas in the process chamber 13 into a plasma 17 using the electric field, and simultaneously performs the etching process on the substrate 19 using the plasma 17. After the etching process is completed, the dry etching apparatus 5 proceeds in the foregoing order with the other process gas, and performs the deposition process on the substrate 19. Thereby, the dry etching apparatus 5 can implement the Bosch process where the etching and deposition processes in the process chamber 13 are sequentially, repeatedly performed in situ.

Now, the Bosch process performed on the substrate 19 will be described. The substrate 19 has a lower layer 60, an upper layer 62, and mask layer patterns 64, all of which are stacked in that order. The mask layer patterns 64 are formed of an insulating layer having an etch rate different from that of the upper layer 62. Further, the mask layer patterns 64 may be formed of an insulating layer having the same etch rate as that of the lower layer 60. A first etching process 66 is performed on the upper layer 62 using the mask layer patterns 64 as an etch mask. In the first etching process 66, the upper layer 62, which is exposed between the mask layer patterns 64, is removed in part, thereby forming a first opening 68.

After performing the first etching process 66, a first deposition process 70 is performed on the mask layer patterns 64 and upper layer 62. The first deposition process 70 forms a first spacer layer 72 so as to conformally cover the mask layer patterns 64 and upper layer 62. The first spacer layer 72 is formed of the insulating layer having the etch rate different from that of the upper layer 62. The first etching and deposition processes 66 and 70 generate the plasma light 23 in the process chamber 13 for a first process time.

Meanwhile, the plasma light 23 is captured in the optical condenser 34 for the first process time of the first etching and deposition processes 66 and 70. The optical condenser 34 captures the plasma light 23 using the optical probe 28. At this time, the optical condenser 34 can capture the plasma light 23 using the algorithm of the operation program in the dry etching apparatus 5 according to the flowchart of FIG. 10. To the end, the optical condenser 34 proceeds from start step S110 to step S112 of "capturing and storing entire plasma light." In step S112 of "capturing and storing entire plasma light," the optical condenser 34 sequentially captures the plasma light 23 of the first etching process 66 and the plasma light 23 of the first deposition process 70 for the first process time.

In order to exclude the influence of the mixture gas while the first etching and deposition processes 66 and 70 are performed, the dry etching apparatus 5 controls the optical condenser 34 to capture the plasma light 23 using the other algorithm of the operation program after a time, which corresponds to an initial section B of FIG. 4 from the time point when the deposition or etching process begins, has lapsed. Subsequently, the optical condenser 34 compares a tolerance of at least one reference value in the operation program with a magnitude of the frequencies of the plasma light 23 using the operation program in "primary comparison" step S114.

If the magnitude of the frequencies of the plasma light 23 meets the reference value tolerance, the optical condenser 34 performs step S116 of "selectively capturing and storing plasma light." In step S116 of "selectively capturing and storing plasma light," the optical condenser 34 captures and stores the plasma light 23 of the first etching process 66 of the first etching and deposition processes 66 and 70. In contrast, if the magnitude of the frequencies of the plasma light 23 does not meet the reference value tolerance, the optical condenser 34 delivers the plasma light 23 from step S116 of "selectively capturing and storing plasma light" to "primary comparison" step S114, and stores the plasma light 23 in "primary comparison" step S114.

Referring to FIGS. 1, 6 and 10, after the first deposition process 70 is performed, a second etching process 74 is performed on the first spacer layer 72, mask layer patterns 64, and upper layer 62. The second etching process 74 forms first spacers 76 on sidewalls of the first opening 68, and a second opening 78 exposed to the first spacers 76 at the same time. The second opening 78 has a width smaller than that of the first opening 68.

After the second etching process 74 is performed, a second deposition process 80 is performed on upper layer 62, together with the mask layer patterns 64 and first spacers 76. The second deposition process 80 forms a second spacer layer 82 so as to conformally cover the mask layer patterns 64, first spacers 76, and upper layer 62. The second spacer layer 82 is formed of an insulating layer having the same etch rate as that of the first spacers 76. The second etching and deposition processes 74 and 80 generate the plasma light 23 in the process chamber 13 for a second process time.

After the second etching and deposition processes 74 and 80 generate the plasma light 23, the optical condenser 34 performs steps S110, S112, S114 and S116 of FIG. 10 on the plasma light 23 of the second etching and deposition processes 74 and 80 using the operation program of the dry etching aparatus 5. Thereby, the optical condenser 34 captures and stores the plasma light 23 of the second etching process of the second etching and deposition processes 74 and 80 in step S116 of "selectively capturing and storing plasma light."

Referring to FIGS. 1, 7 and 10, after the second deposition process 80 is performed, a third etching process 84 is performed on the second spacer layer 82, mask layer patterns 64, first spacers 76 and upper layer 62. The third etching process 84 forms second spacers 86 on sidewalls of the first spacers 76 and second opening 78, and a third opening 88 exposed to the second spacers 86 at the same time. The third opening 88 has a width smaller than that of the second opening 78.

After the third etching process 84 is performed, a third deposition process 90 is performed on upper layer 62, together with the mask layer patterns 64 and second spacers 86. The third deposition process 90 forms a third spacer layer 92 so as to conformally cover the upper layer 62 together with the mask layer patterns 64 and second spacers 86. The third spacer layer 92 is formed of an insulating layer having the same etch rate as that of the second spacers 86. The third etching and deposition processes 84 and 90 generate the plasma light 23 in the process chamber 13 for a third process time.

After the third etching and deposition processes 84 and 90 generate the plasma light 23, the optical condenser 34 performs steps S110, S112, S114 and S116 of FIG. 10 on the plasma light 23 of the third etching and deposition processes 84 and 90 using the operation program of the dry etching apparatus 5. Thereby, the optical condenser 34 captures and stores the plasma light 23 of the third etching process of the third etching and deposition processes 84 and 90 in step S116 of "selectively capturing and storing plasma light."

Referring to FIGS. 1, 8 and 10, after the third deposition process 90 is performed, a fourth etching process 94 is performed on the third spacer layer 92, mask layer patterns 64, second spacers 86 and upper layer 62. The fourth etching process 94 forms third spacers 96 on sidewalls of the second spacers 86 and third opening 88, and a fourth opening 98 exposed to the third spacers 96 at the same time. The fourth opening 98 has a width smaller than that of the third opening 88.

After the fourth etching process 94 is performed, a fourth deposition process 100 is performed on the mask layer patterns 64, third spacers 96, and upper layer 62. The fourth deposition process 100 forms a fourth spacer layer 102 so as to conformally cover the upper layer 62 together with the mask layer patterns 64 and third spacers 96. The fourth spacer layer 102 is formed of an insulating layer having the same etch rate as that of the third spacers 96. The fourth etching and deposition processes 94 and 100 generate the plasma light 23 in the process chamber 13 for a fourth process time.

After the fourth etching and deposition processes 94 and 100 generate the plasma light 23, the optical condenser 34 performs steps S110, S112, S114 and S116 of FIG. 10 on the plasma light 23 of the fourth etching and deposition processes 94 and 100 using the operation program of the dry etching apparatus 5. Thereby, the optical condenser 34 captures and stores the plasma light 23 of the fourth etching process of the fourth etching and deposition processes 94 and 100 in step S116 of "selectively capturing and storing plasma light."

Referring to FIGS. 1, 9 and 10, after the fourth deposition process 100 is performed, a fifth etching process 104 is performed on the fourth spacer layer 102, mask layer patterns 64, third spacers 96 and upper layer 62. The fifth etching process 104 forms fourth spacers 106 on sidewalls of the third spacers 96 and fourth opening 98, and a fifth opening 108 exposed to the fourth spacers 106 at the same time. The fifth opening 108 has a width smaller than that of the fourth opening 98. The fifth etching process 104 generates the plasma light 23 in the process chamber 13 for a fifth process time.

After the fifth etching process 104 generates the plasma light 23, the optical condenser 34 performs steps S110, S112, S114 and S116 of FIG. 10 on the plasma light 23 of the fifth etching process 104 using the operation program of the dry etching apparatus 5. Thereby, the optical condenser 34 captures and stores the plasma light 23 of the fifth etching process 104 in step S116 of "selectively capturing and storing plasma light."

Meanwhile, when the optical screener 50 of FIG. 2 is provided in the dry etching apparatus 5, the optical condenser 34 may capture and store the plasma light 23 using the optical screener 50 in step S116 of "selectively capturing and storing plasma light." This is because a rotation period of the optical screener 50 may be adjusted so as to be the same as a period of repeatedly performing the second etching processes 66, 74, 84, 94 and 104 of the etching and deposition processes 66, 70; 74, 80; 84, 90; 94, 100; and 104 for each process time of the Bosch process, by use of the operation program. At this time, the optical condenser 34 can skip steps S112 and S114 of FIG. 10.

When the signal lines 32 and 33 are used for the optical condenser in the dry etching apparatus, the optical condenser 34 may capture and store the plasma light 23 using the signal lines 32 and 33 in step S116 of "selectively capturing and storing plasma light." At this time, like the case of using the optical screener 50, the optical condenser 34 can also skip steps S112 and S114 of FIG. 10.

Referring to FIGS. 1, 5 to 10 again, when the magnitude of the frequencies of the plasma light 23 of the first to fourth etching processes 66, 74, 84, 94 and 104 meets the tolerance of at least one reference value in the operation program, the optical condenser 34 proceeds from step S116 of "selectively capturing and storing plasma light" of FIG. 10 to step S118 of "checking etching end point." In step S118 of "checking etching end point," the optical condenser 34 delivers the plasma light 23 to the optical analyzer 38. The optical analyzer 38 generates the optical image using the plasma light 23.

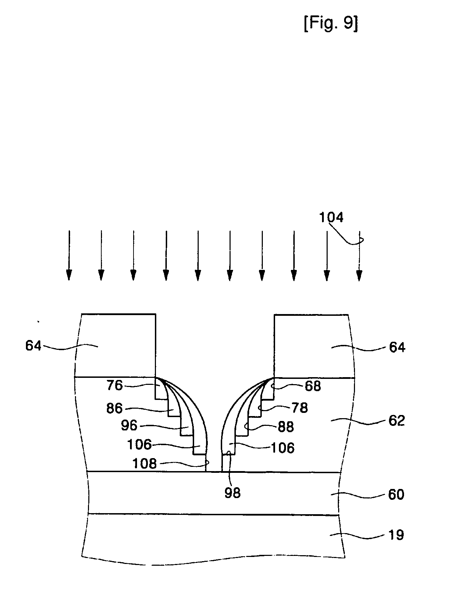

The optical analyzer 38 sends the optical image to the main computer 40. The main computer 40 generates an image locus using the optical image. The image locus is to convert the optical image into binary data. When the lower layer 60 of FIG. 9 is exposed through the upper layer 62, the main computer 40 displays a change in the frequencies of the plasma light 23 on the monitor 45 using the image locus.

The main computer 40 can generate an etch completion signal using the plasma light 23 of the fifth etching process 104 of FIG. 9 in step S118 of "checking etching end point." The main computer 40 can sends the etch completion signal notifying that the lower layer 60 is exposed through the upper layer 62. And the dry etching apparatus 5 receives the etch completion signal from step S118 of "checking etching end point," completes the Bosch process in "end" step S120.

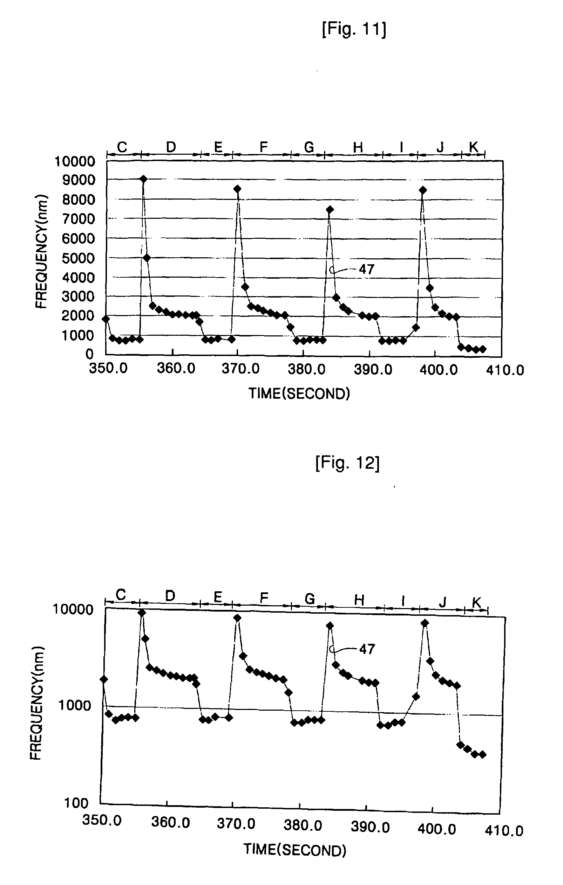

FIGS. 11 and 12 are graphs showing an image locus of plasma light generated while the etching and deposition processes of FIGS. 5 to 9 are performed, respectively.

Referring to FIGS. 1, 5 to 9, 11 and 12, the optical analyzer 38 in the dry etching apparatus 5 can analyze the plasma light 23 generated for each of the first to fifth process times. The optical analyzer 38 can deliver the optical image to the main computer 40. The optical image is formed into a binary data which the main computer 40 can recognize.

The main computer 40 displays a 'zero' order image locus 47 on the monitor 45 using the optical image. The 'zero' order image locus 47 is plotted by use of each of the first to fifth process times, as well as the frequencies of the plasma light 23 corresponding to that time. To be specific, the main computer 40 plots the 'zero' order image locus 47 on the graph using a time (second) on an X axis and frequencies (nm) of the plasma light on a Y axis. The time on the X axis of the graph is constituted of the first to fifth process times that have sequentially lapsed.

Meanwhile, the main computer 40 enables the first to fifth etching processes 66, 74, 84, 94, and 104 performed for the first to fifth process times to correspond to sections C, E, G, I, and K on the 'zero' order image locus 47, respectively. And the main computer 40 enables the first to fourth deposition processes 70, 80, 90, and 100 performed for the first to fourth process times to correspond to sections D, F, H, and J on the 'zero' order image locus 47, respectively. Thereby, the main computer 40 can periodically, repeatedly display the plasma light 23 of the first to fifth etching processes 66, 74, 84, 94, and 104, and the first to fourth deposition processes 70, 80, 90, and 100 on the monitor 45. FIG. 12 is a graph plotted by applying a common logarithm to frequencies of plasma light 23 of FIG. 11.

Referring to FIGS. 1, 5 to 9, 13 and 14, the main computer 40 can display a 'zero' order image locus 48 of the first to fourth deposition processes 70, 80, 90, and 100 performed for the first to fourth process times on the monitor 45. The 'zero' order image locus 48 is plotted by use of the optical image of the optical analyzer 38 which corresponds to each of the first to fourth deposition processes 70, 80, 90, and 100.

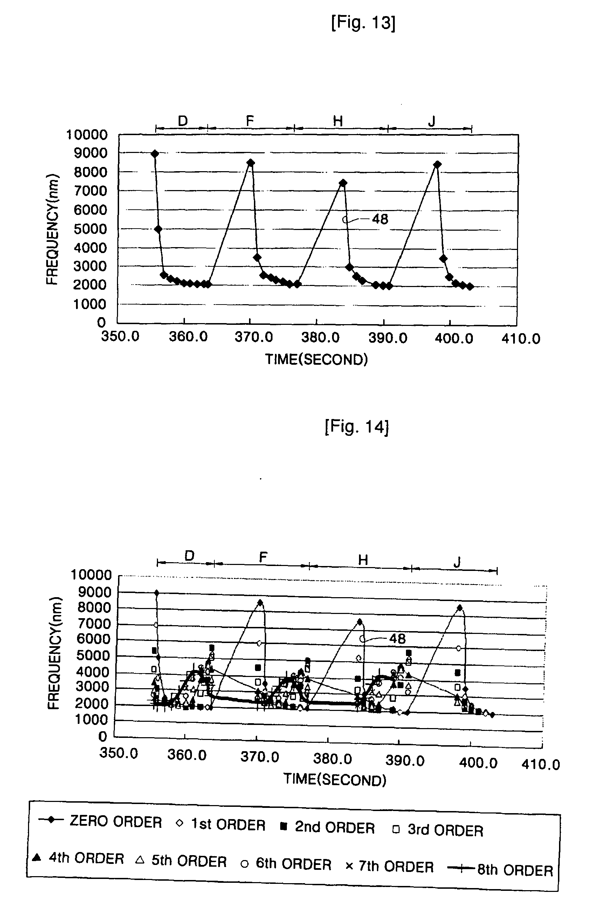

The optical analyzer 38 can form 'zero' order subsequent optical images by applying the moving average method to the optical images once or more. The 'zero' order subsequent optical images are associated with the plasma light 23 of the first to fourth deposition processes 70, 80, 90, and 100 for the first to fourth process times. The main computer 40 can display 'zero' order subsequent image loci on the monitor 45 using the 'zero' order subsequent optical images. The 'zero' order subsequent optical loci make it possible to check a process history associated with the first to fourth deposition processes 70, 80, 90, and 100. The main computer 40 displays the 'zero' to 'eighth' order image loci as shown in FIG. 14 by way of example.

Meanwhile, the moving average method includes a step of dividing the process time of each of the first to fourth deposition processes 70, 80, 90, and 100 of the etching and deposition processes 66, 74, 84, 94 and 104; and 70, 80, 90, and 100 of the Bosch process into a predetermined number of time intervals, and a step of finding a sum of frequencies of the plasma light 23 which correspond to a plurality of time points within any one of the time intervals. Further, the moving average method further includes a step of dividing the sum of the frequencies of the plasma light 23 by a total number of the plurality of time points, and a step of repeatedly performing the step of dividing the sum by the total number using other time intervals.

Referring to FIGS. 1, 5 to 9, 15 and 16, the main computer 40 can display a 'zero' order image locus 49 of the first to fifth etching processes 66, 74, 84, 94 and 104 performed for the first to fifth process times on the monitor 45. The 'zero' order image locus 49 is plotted by use of the optical image of the optical analyzer 38 which corresponds to each of the first to fifth etching processes 66, 74, 84, 94 and 104.

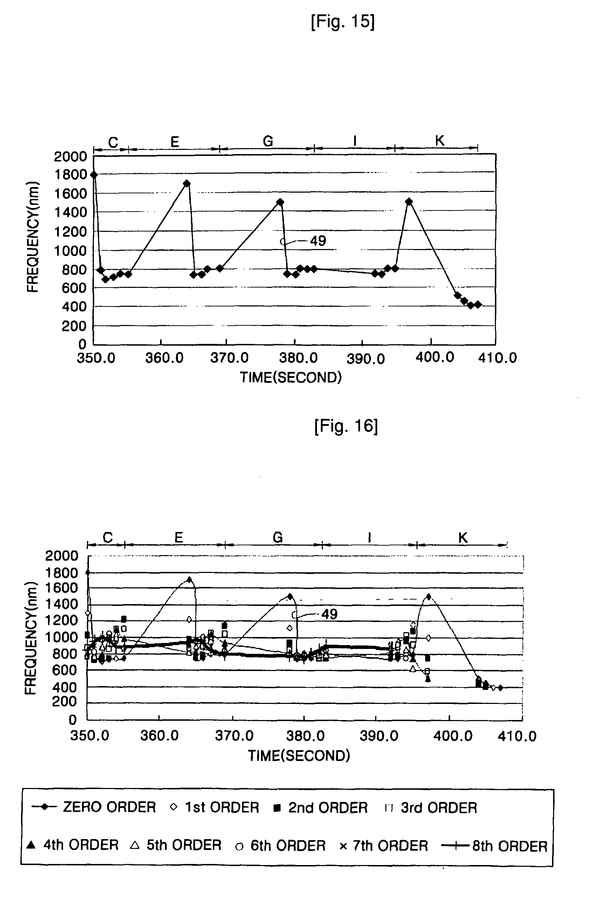

The optical analyzer 38 can form 'zero' order subsequent optical images by applying the moving average method to the optical images once or more. The 'zero' order subsequent optical images are associated with the plasma light 23 of the first to fifth etching processes 66, 74, 84, 94 and 104 for the first to fifth process times. The main computer 40 can display 'zero' order subsequent image loci on the monitor 45 using the 'zero' order subsequent optical images. The 'zero' order subsequent optical loci make it possible to check a process history associated with the first to fifth etching processes 66, 74, 84, 94 and 104. The main computer 40 displays the 'zero' to 'eighth' order image loci as shown in FIG. 16 by way of example.

Meanwhile, the moving average method includes a step of dividing the process time of each of the first to fifth etching processes 66, 74, 84, 94 and 104 of the etching and deposition processes 66, 74, 84, 94 and 104; and 70, 80, 90, and 100 of the Bosch process into a predetermined number of time intervals, and a step of finding a sum of frequencies of the plasma light 23 which correspond to a plurality of time points within any one of the time intervals. Further, the moving average method further includes a step of dividing the sum of the frequencies of the plasma light 23 by a total number of the plurality of time points, and a step of repeatedly performing the step of dividing the sum by the total number using other time intervals.

The moving average method allows the 'zero' to 'eighth' order image loci, which have a relatively smooth waveform as compared with the zero' order image locus 49, to be displayed through the main computer 40. The 'zero' to 'eighth' order image loci are associated with the process gas of the first to fifth etching processes 66, 74, 84, 94 and 104. However the zero to eighth order image loci do not reflect the mixture gas mixed with the process gases of the etching and deposition processes 66, 74, 84, 94 and 104; and 70, 80, 90, and 100. Thus, the main computer 40 enables the etch end point to be stably found from the 'zero' to 'eighth' order image loci including the zero' order image locus 49 as compared with when applying the conventional moving average method.

## Claims

1. A dry etching apparatus adapted to perform etching and deposition processes to generate plasma light (23) in a process, the dry etching apparatus comprising:
a process chamber (13) disposed in the dry etching apparatus (5) an optical window (25) provided at one of sidewalls of the process chamber;
an optical condenser (34) disposed around the optical window; and
an optical analyzer (38) electrically connected to the optical condenser,
wherein the optical window is adapted to project the plasma light out of the process chamber, the optical condenser is adapted to capture the plasma light of the etching or deposition process for a process time of the Bosch process, and the optical analyzer is adapted to analyze the plasma light and transform the plasma light into an optical image, **characterised in that** the dry etching apparatus further comprises an optical probe (28) and an optical screener (50) that are disposed between the optical window and the optical condenser,
wherein the optical screener is disposed opposite to the optical window, and the optical probe has one end disposed opposite to the optical screener and the other end disposed at the optical condenser, wherein the optical screener includes a plurality of apertures (59), and a light shielding layer (53) defining the apertures,
Wherein the optical probe is disposed to face one of the apertures; the apertures are arranged on a circle with a predetermined radius from the center of the light shielding layer; the optical screener is supported to be rotatable around the optical window; and is designed that a period of passing between the apertures of the optical screener is the same as the period of repeatedly performing the etching or deposition process.

2. The dry etching apparatus as claimed in claim 1, wherein the optical condenser includes an optical filter, a monochrometer, or a charge coupled device (CCD).

3. The dry etching apparatus as claimed in claim 2, wherein the optical condenser is adapted to capture the plasma light having a resolution of 0.1 to 10 nm and a frequency of a wavelength range of 200 to 1100 nm.

4. The dry etching apparatus as claimed in claim 1, wherein the optical probe includes an optical fiber.

5. The dry etching apparatus as claimed in claim 1, further comprising an optical probe disposed between the optical window and the optical condenser, and signal lines disposed at the optical condenser,
wherein the signal lines have two electrical nodes and a switch for connecting or disconnecting the electrical nodes, and the optical probe has one end extending through the optical window into the process chamber and the other end disposed at the optical condenser.

6. The dry etching apparatus as claimed in claim 5, wherein a period at which the electrical nodes are connected and disconnected by the switch is the same as the period of performing the etching and deposition processes.

7. The dry etching apparatus as claimed in claim 5, wherein a period at which the electrical nodes are connected and disconnected by the switch is the same as the period of performing the deposition and etching processes.

8. The dry etching apparatus as claimed in claim 5, wherein the optical condenser includes an optical filter, a monochrometer, or a charge coupled device (CCD).

9. The dry etching apparatus as claimed in claim 8, wherein the optical condenser is adapted to capture the plasma light having a resolution of 0.1 to 10 nm and a frequency of a wavelength range of 200 to 1100 nm.

10. The dry etching apparatus as claimed in claim 9, wherein the optical probe includes an optical fiber.

11. The dry etching apparatus as claimed in claim 1, further comprising an optical probe disposed between the optical window and the optical condenser,
wherein the dry etching apparatus has a tolerance of at least one reference value in an operation program.

12. The dry etching apparatus as claimed in any one of claims 1, 5 and 11, wherein the optical condenser is adapted to capture the plasma light after a time, which corresponds to an initial section from the time point when the deposition or etching process begins, has lapsed.

13. The dry etching apparatus as claimed in claim 1, further comprising a main computer electrically connected to the optical analyzer,
wherein the main computer is adapted to receive the optical image from the optical analyzer to generate a 'zero' order image locus, and the optical analyzer is adapted to apply an arithmetic operation to the optical image at least once and to provide binary data corresponding to 'zero' order subsequent image loci to the main computer.

14. The dry etching apparatus as claimed in claim 1, further comprising lower and upper electrodes disposed in the process chamber.

15. The dry etching apparatus as claimed in claim 1, further comprising a lower electrode and a magnetic field generator around the process chamber to correspond to the lower electrode in the process chamber.

16. A method of forming an electric device using a dry etching apparatus (5) adapted to perform etching and deposition processes to generate plasma light in a Bosch process; the method comprising:
introducing a substrate into a process chamber (13);
sequentially and repeatedly performing etching and deposition processes on the substrate to form plasma light;
after a time, which corresponds to an initial section from the time point when the deposition or etching process begins, has lapsed, selectively and periodically capturing the plasma light to form an optical image; and
applying an arithmetic operation to the optical image to form at least one image locus,
**characterised in that** selectively and periodically capturing the plasma light includes:
disposing an optical window (25) on a sidewall of the process chamber, the optical window projecting the plasma light from the process chamber while the etching and deposition processes are performed;
disposing an optical condenser (34) around the optical window; and
providing an optical probe (28) and an optical screener (50) between the optical window and the optical condenser,
wherein the optical screener is formed to make a rotation motion around the optical window; the optical screener induces a plurality of apertures and a light shielding layer (53) defining the apertures (59); the apertures are arranged on a circle with a predetermined radius from the center of the light shielding layer; the rotation motion of the optical screener separates the plasma light according to a process time of the Bosch process; and the optical probe has one end formed to face one of the apertures of the optical screener and the other end disposed at the optical condenser.

17. The method as claimed in claim 16, wherein the arithmetic operation makes use of a moving average method, and the moving average method includes dividing a process time of each of the etching and deposition processes into predetermined time intervals and finding a sum of frequencies of the plasma light which correspond to a plurality of points of time within any one of the time intervals, subsequently dividing the sum of the frequencies of the plasma light by a total number of the plurality of time points, and repeatedly performing the above using other time intervals.

18. The method as claimed in claim 17, wherein a total number of the time points is a sum of the time points of repeatedly measuring the plasma light.

19. The method as claimed in claim 16, wherein selectively and periodically capturing the plasma light includes:
disposing an optical window on a sidewall of the process chamber, the optical window projecting the plasma light from the process chamber while the etching and deposition processes are performed;
disposing an optical condenser around the optical window; and
providing an optical probe between the optical window and the optical condenser,
wherein an operation program for the dry etching apparatus compares a tolerance of at least one reference value in the operation program with a magnitude of frequencies of the plasma light, determines the comparison result, and separates the plasma light according to a process time of the Bosch process.

20. The method as claimed in claim 19, wherein the optical condenser includes an optical filter, a monochrometer, or a charge coupled device (CCD).

21. The method as claimed in claim 20, wherein the plasma light has a resolution of 0.1 to 10 nm and a frequency of a wavelength range of 200 to 1100 nm.

22. The method as claimed in claim 16, wherein the optical condenser includes an optical filter, a monochrometer, or a charge coupled device (CCD).

23. The method as claimed in claim 22, wherein the plasma light has a resolution of 0.1 to 10 nm and a frequency of a wavelength range of 200 to 1100 nm.

24. The method as claimed in claim 16, wherein selectively and periodically capturing the plasma light includes:
disposing an optical window on a sidewall of the process chamber, the optical window projecting the plasma light from the process chamber while the etching and deposition processes are performed;
disposing an optical condenser around the optical window; and
providing an optical probe between the optical window and the optical condenser, and signal lines at the optical condenser,
wherein the signal lines have two electrical nodes and a switch for connecting or disconnecting the electrical nodes; the connection or disconnection of the electrical nodes separates the plasma light according to a process time of the Bosch process; and the optical probe has one end extending through the optical window into the process chamber and the other end disposed at the optical condenser

25. The method as claimed in claim 24, wherein a period at which the electrical nodes are connected and disconnected by the switch is the same as the period of performing the etching and deposition processes.

26. The method as claimed in claim 24, wherein a period at which the electrical nodes are connected and disconnected by the switch is the same as the period of performing the deposition and etching processes.

27. The method as claimed in claim 24, wherein the optical condenser includes an optical filter, a monochrometer, or a charge coupled device (CCD).

28. The method as claimed in claim 27, wherein the plasma light has a resolution of 0.1 to 10 nm and a frequency of a wavelength range of 200 to 1100 nm.

29. The method as claimed in claim 16, 18 or 24, wherein forming the optical image includes:
providing an optical analyzer electrically connected to the optical condenser;
and
converting the plasma light into electrical data using the optical analyzer.

30. The method as claimed in claim 16, wherein forming at least one image locus includes:
providing a main computer electrically connected to the optical analyzer,
wherein the optical analyzer applies a moving average method to the optical image once or more to generate binary data, and the main computer display the binary data on a monitor according to a process time of the Bosch process.

31. The method as claimed in claim 16, further comprising forming lower and upper electrodes in the process chamber.

32. The method as claimed in claim 16, further comprising forming a lower electrode and a magnetic field generator around the process chamber to correspond to the lower electrode in the process chamber.

## Patentansprüche

1. Trockenätzvorrichtung, ausgebildet zur Durchführung von Ätz- und Abscheidungsverfahren zur Erzeugung von Plasmalicht (23) in einem Bosch-Prozess, wobei die Trockenätzvorrichtung aufweist:
eine Prozesskammer (13), die in der Trockenätzvorrichtung (5) angeordnet ist;
ein optisches Fenster (25), das auf einer der Seitenwände der Prozesskammer vorgesehen ist;
einen optischen Kondensor (34), der um das optische Fenster herum angeordnet ist; und
einen optischen Analysator (38), der mit dem optischen Kondensor elektrisch verbunden ist,
wobei das optische Fenster zum Projizieren von Plasmalicht aus der Prozesskammer ausgebildet ist, wobei der optische Kondensor zum Erfassen des Plasmalichts des Ätz- oder Abscheidungsverfahrens während einer Verfahrenszeit des Bosch-Prozesses ausgebildet ist, und wobei der optische Analysator zur Analyse des Plasmalichts und zur Umwandlung des Plasmalichts in ein optisches Bild ausgebildet ist, **dadurch gekennzeichnet, dass** die Trockenätzvorrichtung weiterhin eine optische Sonde (28) und einen optischen Screener (50), die zwischen dem optischen Fenster und dem optischen Kondensor angeordnet sind, umfasst,
wobei der optische Screener dem optischen Fenster gegenüberliegend angeordnet ist, und wobei die optische Sonde ein Ende aufweist, das dem optischen Screener gegenüberliegend angeordnet ist, während das andere Ende am optischen Kondensor angeordnet ist, wobei der optische Screener eine Vielzahl von Öffnungen (59) und eine lichtabschirmende Schicht (53), die die Öffnungen definiert, aufweist,
wobei die optische Sonde derart angeordnet ist, dass sie einer der Öffnungen zugewandt ist; wobei die Öffnungen auf einem Kreis mit einem vorbestimmten Radius von der Mitte der lichtabschirmenden Schicht angeordnet sind; wobei der optische Screener so gelagert ist, dass er um das optische Fenster drehbar ist, und so konzipiert ist, dass eine Periode des Durchlaufens zwischen den Öffnungen des optischen Screeners die gleiche ist wie die Periode des wiederholten Durchführens des Ätz- oder Abscheidungsverfahrens.

2. Trockenätzvorrichtung nach Anspruch 1, wobei der optische Kondensor einen optischen Filter, einen Monochromator oder eine ladungsgekoppelte Vorrichtung (CCD = charge coupled device) aufweist.

3. Trockenätzvorrichtung nach Anspruch 2, wobei der optische Kondensor zum Erfassen von Plasmalicht ausgebildet ist, das eine Auflösung von 0,1 bis 10 nm und eine Frequenz eines Wellenlängenbereichs von 200 bis 1100 nm aufweist.

4. Trockenätzvorrichtung nach Anspruch 1, wobei die optische Sonde eine optische Faser aufweist.

5. Trockenätzvorrichtung nach Anspruch 1, weiterhin aufweisend eine optische Sonde, die zwischen dem optischen Fenster und dem optischen Kondensor angeordnet ist, und Signalleitungen, die am optischen Kondensor angeordnet sind,
wobei die Signalleitungen zwei elektrische Knoten und einen Schalter zur Verbindung oder Trennung der elektrischen Knoten aufweisen, und wobei die optische Sonde ein Ende aufweist, das sich durch das optische Fenster in die Prozesskammer erstreckt, während das andere Ende am optischen Kondensor angeordnet ist.

6. Trockenätzvorrichtung nach Anspruch 5, wobei eine Periode, in der die elektrischen Knoten durch den Schalter verbunden und getrennt werden, der Periode zur Durchführung des Ätz- und Abscheidungsverfahrens entspricht.

7. Trockenätzvorrichtung nach Anspruch 5, wobei eine Periode, in der die elektrischen Knoten durch den Schalter verbunden und getrennt werden, der Periode zur Durchführung des Abscheidungs- und Ätzverfahrens entspricht.

8. Trockenätzvorrichtung nach Anspruch 5, wobei der optische Kondensor einen optischen Filter, einen Monochromator oder eine ladungsgekoppelte Vorrichtung (CCD = charge coupled device) aufweist.

9. Trockenätzvorrichtung nach Anspruch 8, wobei der optische Kondensor zum Erfassen von Plasmalicht ausgebildet ist, das eine Auflösung von 0,1 bis 10 nm und eine Frequenz eines Wellenlängenbereichs von 200 bis 1100 nm aufweist.

10. Trockenätzvorrichtung nach Anspruch 9, wobei die optische Sonde eine optische Faser aufweist.

11. Trockenätzvorrichtung nach Anspruch 1, weiterhin aufweisend eine optische Sonde, die zwischen dem optischen Fenster und dem optischen Kondensor angeordnet ist,
wobei die Trockenätzvorrichtung eine Toleranz von zumindest einem Referenzwert in einem Betriebsprogramm aufweist.

12. Trockenätzvorrichtung nach einem der Ansprüche 1, 5 und 11, wobei der optische Kondensor ausgebildet ist, das Plasmalicht nach Ablauf eines Zeitraums zu erfassen, der einem Anfangsabschnitt von dem Zeitpunkt an, an dem das Abscheidungs- oder Ätzverfahren beginnt, entspricht.

13. Trockenätzverfahren nach Anspruch 1, weiterhin aufweisend einen Hauptcomputer, der mit dem optischen Analysator elektrisch verbunden ist,
wobei der Hauptcomputer zum Erhalt des optischen Bildes vom optischen Analysator zur Erzeugung eines Bildorts nullter Ordnung ausgebildet ist, und wobei der optische Analysator ausgebildet ist, zumindest einmal eine Rechenoperation auf das optische Bild anzuwenden und den Hauptcomputer mit binären Daten zu versorgen, die den der nullten Ordnung folgenden Bildorten entsprechen.

14. Trockenätzvorrichtung nach Anspruch 1, weiterhin aufweisend eine obere und untere Elektrode, die in der Prozesskammer angeordnet sind.

15. Trockenätzvorrichtung nach Anspruch 1, weiterhin aufweisend eine untere Elektrode und einen Magnetfeldgenerator um die Prozesskammer herum, die mit der unteren Elektrode in der Prozesskammer korrespondieren.

16. Verfahren zur Ausbildung einer elektrischen Vorrichtung mittels einer Trockenätzvorrichtung (5), die zur Durchführung von Ätz- und Abscheidungsverfahren zur Erzeugung von Plasmalicht in einem Bosch-Prozess ausgebildet ist, wobei das Verfahren folgende Verfahrensschritte umfasst:
Einführen eines Substrats in eine Prozesskammer (13);
nacheinander und wiederholt erfolgendes Durchführen von Ätz- und Abscheidungsverfahren auf dem Substrat zur Ausbildung von Plasmalicht;
selektives und periodisches Erfassen des Plasmalichts zur Ausbildung eines optischen Bildes nach Ablauf eines Zeitraums, der einem Anfangsabschnitt von dem Zeitpunkt an, an dem das Abscheidungs- oder Ätzverfahren beginnt, entspricht; und
Anwenden einer Rechenoperation auf das optische Bild zur Ausbildung zumindest eines Bildorts;
**dadurch gekennzeichnet, dass** das selektive und periodische Erfassen des Plasmalichts aufweist:
Anordnen eines optischen Fensters (25) auf einer Seitenwand der Prozesskammer, wobei das optische Fenster das Plasmalicht von der Prozesskammer projiziert, während das Ätz- und Abscheidungsverfahren durchgeführt werden;
Anordnen eines optischen Kondensors (34) um das optische Fenster herum;
und
Bereitstellen einer optischen Sonde (28) und eines optischen Screeners (50) zwischen dem optischen Fenster und dem optischen Kondensor,
wobei der optische Screener derart ausgebildet ist, dass er eine Rotationsbewegung um das optische Fenster vollführt; wobei der optische Screener eine Vielzahl von Öffnungen und eine lichtabschirmende Schicht (53), die die Öffnungen (59) definiert, aufweist; wobei die Öffnungen auf einem Kreis mit einem vorbestimmten Radius von der Mitte der lichtabschirmenden Schicht angeordnet sind, wobei die Rotationsbewegung des optischen Screeners das Plasmalicht gemäß einer Verfahrenszeit des Boschprozesses trennt; und wobei die optische Sonde ein Ende aufweist, das derart ausgebildet ist, dass es einer der Öffnungen des optischen Screeners zugewandt ist, während das andere Ende am optischen Kondensor angeordnet ist.

17. Verfahren nach Anspruch 16, wobei die Rechenoperation ein Verfahren des gleitenden Mittelwerts einsetzt, und wobei das Verfahren des gleitenden Mittelwerts die Unterteilung einer Verfahrenszeit von jedem des Ätz- und Abscheidungsverfahrens in vorbestimmte Zeitintervalle und das Finden einer Summe von Frequenzen des Plasmalichts, die einer Vielzahl von Zeitpunkten in einem beliebigen der Zeitintervalle entspricht, aufweist, wobei die Summe der Frequenzen des Plasmalichts anschließend durch eine Gesamtzahl der Vielzahl von Zeitpunkten geteilt wird, und wobei das oben genannte Verfahren unter Verwendung anderer Zeitintervalle wiederholt durchgeführt wird.

18. Verfahren nach Anspruch 17, wobei eine Gesamtzahl der Zeitpunkte eine Summe der Zeitpunkte des wiederholten Messens des Plasmalichts ist.

19. Verfahren nach Anspruch 16, wobei das selektive und periodische Erfassen des Plasmalichts aufweist:
Anordnen eines optischen Fensters auf einer Seitenwand der Prozesskammer, wobei das optische Fenster das Plasmalicht aus der Prozesskammer projiziert, während das Ätz- und Abscheidungsverfahren durchgeführt werden;
Anordnen eines optischen Kondensors um das optische Fenster herum; und
Bereitstellen einer optischen Sonde zwischen dem optischen Fenster und dem optischen Kondensor,
wobei ein Betriebsprogramm für die Trockenätzvorrichtung eine Toleranz von zumindest einem Referenzwert in dem Betriebsprogramm mit einem Betrag von Frequenzen des Plasmalichts vergleicht, das Vergleichsergebnis bestimmt und das Plasmalicht gemäß einer Verfahrenszeit des Bosch-Prozesses trennt.

20. Verfahren nach Anspruch 19, wobei der optische Kondensor einen optischen Filter, einen Monochromator oder eine ladungsgekoppelte Vorrichtung (CCD = charge coupled device) aufweist.

21. Verfahren nach Anspruch 20, wobei das Plasmalicht eine Auflösung von 0,1 bis 10 nm und eine Frequenz eines Wellenlängenbereichs von 200 bis 1100 nm aufweist.

22. Verfahren nach Anspruch 16, wobei der optische Kondensor einen optischen Filter, einen Monochromator oder eine ladungsgekoppelte Vorrichtung (CCD = charge coupled device) aufweist.

23. Verfahren nach Anspruch 22, wobei das Plasmalicht eine Auflösung von 0,1 bis 10 nm und eine Frequenz eines Wellenlängenbereichs von 200 bis 1100 nm aufweist

24. Verfahren nach Anspruch 16, wobei das selektive und periodische Erfassen des Plasmalichts aufweist:
Anordnen eines optischen Fensters auf einer Seitenwand der Prozesskammer, wobei das optische Fenster das Plasmalicht aus der Prozesskammer projiziert, während das Ätz- und Abscheidungsverfahren durchgeführt werden;
Anordnen eines optischen Kondensors um das optische Fenster herum; und
Bereitstellen einer optischen Sonde zwischen dem optischen Fenster und dem optischen Kondensor, und von Signalleitungen am optischen Kondensor,
wobei die Signalleitungen zwei elektrische Knoten und einen Schalter zur Verbindung oder Trennung der elektrischen Knoten aufweisen, wobei die Verbindung oder Trennung der elektrischen Knoten das Plasmalicht gemäß einer Verfahrenszeit des Boschprozesses trennt; und wobei die optische Sonde ein Ende aufweist, das sich durch das optische Fenster in die Prozesskammer erstreckt, während das andere Ende am optischen Kondensor angeordnet ist.

25. Verfahren nach Anspruch 24, wobei eine Periode, in der die elektrischen Knoten durch den Schalter verbunden und getrennt sind, der Periode zur Durchführung des Ätz- und Abscheidungsverfahrens entspricht.

26. Verfahren nach Anspruch 24, wobei eine Periode, in der die elektrischen Knoten durch den Schalter verbunden und getrennt werden, der Periode zur Durchführung der Abscheidungs- und Ätzverfahren entspricht.

27. Verfahren nach Anspruch 24, wobei der optische Kondensor einen optischen Filter, einen Monochromator oder eine ladungsgekoppelte Vorrichtung (CCD = charge coupled device) aufweist.

28. Verfahren nach Anspruch 27, wobei das Plasmalicht eine Auflösung von 0,1 bis 10 nm und eine Frequenz eines Wellenlängenbereichs von 200 bis 1100 nm aufweist.

29. Verfahren nach Anspruch 16, 18 oder 24, wobei die Ausbildung des optischen Bildes aufweist:
Bereitstellen eines optischen Analysators, der mit dem optischen Kondensor elektrisch verbunden ist; und
Umwandlung des Plasmalichts in elektrische Daten mittels des optischen Analysators.

30. Verfahren nach Anspruch 16, wobei die Ausbildung zumindest eines Bildorts aufweist:
Bereitstellen eines Hauptcomputers, der mit dem optischen Analysator elektrisch verbunden wird,
wobei der optische Analysator einmal oder mehrere Male ein Verfahren des gleitenden Mittelwerts auf das optische Bild anwendet, um binäre Daten zu erzeugen, und wobei der Hauptcomputer die binären Daten gemäß einer Verfahrenszeit des Bosch-Prozesses auf einem Monitor anzeigt.

31. Verfahren nach Anspruch 16, weiterhin aufweisend die Ausbildung einer oberen und unteren Elektrode in der Prozesskammer.

32. Verfahren nach Anspruch 16, weiterhin aufweisend die Ausbildung einer unteren Elektrode und eines Magnetfeldgenerators um die Prozesskammer herum, die mit der unteren Elektrode in der Prozesskammer korrespondieren.

## Revendications

1. Appareil de gravure sèche adapté pour effectuer des procédés de gravure et de dépôt pour générer de la lumière (23) à plasma dans un procédé de Bosch, l'appareil de gravure sèche comprenant :
une chambre (13) de traitement disposée dans l'appareil (5) de gravure sèche,
une fenêtre (25) optique prévue à une des parois latérales de la chambre de traitement ;
un condenseur (34) optique disposé autour de la fenêtre optique ; et
un analyseur (38) optique connecté électriquement au condenseur optique,
la fenêtre optique étant adaptée pour projeter la lumière à plasma hors de la chambre de traitement, le condenseur optique étant adapté pour capter la lumière à plasma du procédé de gravure ou de dépôt pendant une durée de traitement du procédé de Bosch, et l'analyseur optique étant adapté pour analyser la lumière à plasma et pour transformer la lumière à plasma en image optique, **caractérisé en ce que** l'appareil de gravure sèche comprend en outre une sonde (28) optique et un dispositif (50) de tamisage optique (optical screener) disposés entre la fenêtre optique et le condenseur optique,
le dispositif de tamisage optique étant disposé de manière à être opposé à la fenêtre optique, et la sonde optique ayant une extrémité disposée de manière à être opposée au dispositif de tamisage optique et l'autre extrémité disposée au condenseur optique, le dispositif de tamisage optique comprenant une pluralité d'ouvertures (59) et une couche (53) de protection contre la lumière définissant les ouvertures,
la sonde optique étant disposée de manière à faire face à une des ouvertures ;
les ouvertures étant disposées sur un cercle ayant un rayon prédéterminé à partir du centre de la couche de protection contre la lumière; le dispositif de tamisage optique étant supporté de façon rotative autour de la fenêtre optique, et étant conçu de telle manière qu'une période de passage entre les ouvertures du dispositif de tamisage optique corresponde à la période mise à effectuer de façon répétée le procédé de gravure ou de dépôt.

2. Appareil de gravure sèche selon la revendication 1, dans lequel le condenseur optique comprend un filtre optique, un monochromateur, ou un dispositif à transfert de charge (CCD = charge coupled device).

3. Appareil de gravure sèche selon la revendication 2, dans lequel le condenseur optique est adapté pour capter la lumière à plasma ayant une résolution de 0,1 à 10 nm et une fréquence d'une gamme de longueur d'onde de 200 à 1100 nm.

4. Appareil de gravure sèche selon la revendication 1, dans lequel la sonde optique comprend une fibre optique.

5. Appareil de gravure sèche selon la revendication 1, comprenant en outre une sonde optique disposée entre la fenêtre optique et le condenseur optique, et des lignes de signaux disposées au condenseur optique,
les lignes de signaux ayant deux noeuds électriques et un commutateur pour connecter et déconnecter les noeuds électriques, et la sonde optique ayant une extrémité s'étendant dans la chambre de traitement, par la fenêtre optique, et l'autre extrémité disposée au condenseur optique.

6. Appareil de gravure sèche selon la revendication 5, dans lequel une période dans laquelle les noeuds électriques sont connectés et déconnectés par le commutateur correspond à la période mise à effectuer les procédés de gravure et de dépôt.

7. Appareil de gravure sèche selon la revendication 5, dans lequel une période dans laquelle les noeuds électriques sont connectés et déconnectés par le commutateur correspond à la période mise à effectuer les procédés de dépôt et de gravure.

8. Appareil de gravure sèche selon la revendication 5, dans lequel le condenseur optique comprend un filtre optique, un monochromateur, ou un dispositif à transfert de charge (CCD = charge coupled device).

9. Appareil de gravure sèche selon la revendication 8, dans lequel le condenseur optique est adapté pour capter la lumière à plasma ayant une résolution de 0,1 à 10 nm et une fréquence d'une gamme de longueur d'onde de 200 à 1100 nm.

10. Appareil de gravure sèche selon la revendication 9, dans lequel la sonde optique comprend une fibre optique.

11. Appareil de gravure sèche selon la revendication 1, comprenant en outre une sonde optique disposée entre la fenêtre optique et le condenseur optique,
l'appareil de gravure sèche ayant une tolérance d'au moins une valeur de référence dans un programme d'opération.

12. Appareil de gravure sèche selon l'une des revendications 1, 5 et 11, dans lequel le condenseur optique est adapté pour capter la lumière à plasma après qu'une durée se soit écoulée qui correspond à une section initiale à partir du moment où commence le procédé de dépôt ou de gravure.

13. Appareil de gravure sèche selon la revendication 1, comprenant en outre un ordinateur principal connecté électriquement à l'analyseur optique,
l'ordinateur principal étant adapté pour recevoir l'image optique de l'analyseur optique afin de générer un lieu d'image d'ordre zéro, et l'analyseur optique étant adapté pour appliquer une opération arithmétique à l'image optique au moins une fois, et pour fournir des données binaires à l'ordinateur principal qui correspondent à des lieux d'image suivant l'ordre zéro.

14. Appareil de gravure sèche selon la revendication 1, comprenant en outre des électrodes inférieure et supérieure disposées dans la chambre de traitement.

15. Appareil de gravure sèche selon la revendication 1, comprenant en outre une électrode inférieure et un générateur de champs magnétique situés autour de la chambre de traitement et conçus pour correspondre avec l'électrode inférieure située dans la chambre de traitement.

16. Procédé de formation d'un dispositif électrique utilisant un appareil (5) de gravure sèche adapté pour effectuer des procédés de gravure et de dépôt pour générer de la lumière à plasma dans un procédé de Bosch, le procédé comprenant :
introduire un substrat dans uns chambre (13) de traitement ;
effectuer de manière séquentielle et répétée des procédés de gravure et de dépôt sur le substrat pour former de la lumière à plasma ;
capter de manière sélective et périodique la lumière à plasma pour former une image optique après qu'une durée se soit écoulée qui correspond à une section initiale à partir du moment où commence le procédé de dépôt ou de gravure ; et
appliquer une opération arithmétique à l'image optique pour former au moins un lieu d'image,
**caractérisé en ce que** la capture sélective et périodique de la lumière à plasma comprend :
disposer une fenêtre (25) optique sur une paroi latérale de la chambre de traitement, la fenêtre optique projetant la lumière à plasma hors de la chambre de traitement alors que les procédés de gravure et de dépôt sont effectués ;
disposer un condenseur (34) optique autour de la fenêtre optique ; et
prévoir une sonde (28) optique et un dispositif (50) de tamisage optique (optical screener) entre la fenêtre optique et le condenseur optique,
le dispositif de tamisage optique étant formé de manière à effectuer un mouvement de rotation autour de la fenêtre optique ; le dispositif de tamisage optique comprenant une pluralité d'ouvertures et une couche (53) de protection contre la lumière définissant les ouvertures (59) ; les ouvertures étant disposées sur un cercle ayant un rayon prédéterminé à partir du centre de la couche de protection contre la lumière; le mouvement de rotation du dispositif de tamisage optique séparant la lumière à plasma en fonction d'une durée de traitement du procédé de Bosch; et la sonde optique ayant une extrémité formée de manière à faire face à l'une des ouvertures du dispositif de tamisage optique et l'autre extrémité disposée au condenseur optique.

17. Procédé selon la revendication 16, dans lequel l'opération arithmétique utilise un procédé de moyenne mobile, le procédé de moyenne mobile comprenant la division d'une durée de traitement de chacun des procédés de gravure et de dépôt en intervalles de temps prédéterminés et l'acte de trouver une somme de fréquences de la lumière à plasma correspondant à une pluralité de moments dans un quelconque des intervalles de temps, la division suivante de la somme des fréquences de la lumière à plasma par un nombre total de la pluralité de moments, et la réalisation répétée du susdit en utilisant d'autres intervalles de temps.

18. Procédé selon la revendication 17, dans lequel un nombre total des moments est une somme des moments de la mesure répétée de la lumière à plasma.

19. Procédé selon la revendication 16, dans lequel la capture sélective et périodique de la lumière à plasma comprend :
disposer une fenêtre optique sur une paroi latérale de la chambre de traitement, la fenêtre optique projetant la lumière à plasma hors de la chambre de traitement alors que les procédés de gravure et de dépôt sont effectués ;
disposer un condenseur optique autour de la fenêtre optique ; et
prévoir une sonde optique entre la fenêtre optique et le condenseur optique,
un programme d'opération conçu pour l'appareil de gravure sèche comparant une tolérance d'au moins une valeur de référence dans le programme d'opération à une magnitude de fréquences de la lumière à plasma, déterminant le résultat de la comparaison, et séparant la lumière à plasma en fonction d'une durée de traitement du procédé de gravure ionique réactive profonde (procédé de Bosch).

20. Procédé selon la revendication 19, dans lequel le condenseur optique comprend un filtre optique, un monochromateur, ou un dispositif à transfert de charge (CCD = charge coupled device).

21. Procédé selon la revendication 20, dans lequel la lumière à plasma a une résolution de 0,1 à 10 nm et une fréquence d'une gamme de longueur d'onde de 200 à 1100 nm.

22. Procédé selon la revendication 16, dans lequel le condenseur optique comprend un filtre optique, un monochromateur, ou un dispositif à transfert de charge (CCD = charge coupled device).

23. Procédé selon la revendication 22, dans lequel la lumière à plasma a une résolution de 0,1 à 10 nm et une fréquence d'une gamme de longueur d'onde de 200 à 1100 nm.

24. Procédé selon la revendication 16, dans lequel la capture sélective et périodique de la lumière à plasma comprend :
disposer une fenêtre optique sur une paroi latérale de la chambre de traitement, la fenêtre optique projetant la lumière à plasma hors de la chambre de traitement alors que les procédés de gravure et de dépôt sont effectués ;
disposer un condenseur optique autour de la fenêtre optique ; et
prévoir une sonde optique entre la fenêtre optique et le condenseur optique, et des lignes de signaux au condenseur optique,
les lignes de signaux ayant deux noeuds électriques et un commutateur pour connecter et déconnecter les noeuds électriques ; la connexion ou déconnexion des noeuds électriques séparant la lumière à plasma en fonction d'une durée de traitement du procédé de gravure ionique réactive profonde (procédé de Bosch) ; et la sonde optique ayant une extrémité s'étendant dans la chambre de traitement, par la fenêtre optique, et l'autre extrémité disposée au condenseur optique.

25. Procédé selon la revendication 24, dans lequel une période dans laquelle les noeuds électriques sont connectés et déconnectés par le commutateur correspond à la période mise à effectuer les procédés de gravure et de dépôt.

26. Procédé selon la revendication 24, dans lequel une période dans laquelle les noeuds électriques sont connectés et déconnectés par le commutateur correspond à la période mise à effectuer les procédés de dépôt et de gravure.

27. Procédé selon la revendication 24, dans lequel le condenseur optique comprend un filtre optique, un monochromateur, ou un dispositif à transfert de charge (CCD = charge coupled device).

28. Procédé selon la revendication 27, dans lequel la lumière à plasma a une résolution de 0,1 à 10 nm et une fréquence d'une gamme de longueur d'onde de 200 à 1100 nm.

29. Procédé selon la revendication 16, 18, ou 24, dans lequel la formation de la fenêtre optique comprend :
prévoir un analyseur optique connecté électriquement au condenseur optique ;
et
convertir la lumière à plasma en données électriques au moyen de l'analyseur optique.

30. Procédé selon la revendication 16, dans lequel la formation d'au moins un lieu d'image comprend :
prévoir un ordinateur principal connecté électriquement à l'analyseur optique,
l'analyseur optique appliquant un procédé de moyenne mobile à l'image optique une fois ou plusieurs fois pour générer des données binaires, et l'ordinateur principal affichant les données binaires sur un moniteur en fonction d'une durée de traitement du procédé de gravure ionique réactive profonde (procédé de Bosch).

31. Procédé selon la revendication 16, comprenant en outre la formation d'électrodes inférieure et supérieure dans la chambre de traitement.

32. Procédé selon la revendication 16, comprenant en outre la formation d'une électrode inférieure et d'un générateur de champs magnétique autour de la chambre de traitement conçus pour correspondre avec l'électrode inférieure située dans la chambre de traitement.
